# EUROPÄISCHE PATENTSCHRIFT

(11) **EP 1 095 400 B1**
(45) Veröffentlichungstag und Bekanntmachung des Hinweises auf die Patenterteilung: **29.10.2008**
(21) Anmeldenummer: 00929216.0
(22) Anmeldetag: 16.03.2000
(51) Int. Cl.: H01L 21/3065

(54) **VERFAHREN ZUM PLASMAÄTZEN VON SILIZIUM**
METHODS FOR PLASMA ETCHING SILICON
PROCEDE D'ATTAQUE DE SILICIUM PAR PLASMA

(30) Priorität: 29.04.1999 DE 19919469
(43) Veröffentlichungstag der Anmeldung: 02.05.2001
(73) Patentinhaber: ROBERT BOSCH GMBH, 70442 Stuttgart (DE)
(72) Erfinder: LAERMER, Franz, D-70437 Stuttgart (DE); SCHILP, Andrea, D-73525 Schwäbisch Gmünd (DE); ELSNER, Bernhard, D-70806 Kornwestheim (DE)
(86) Internationale Anmeldenummer: PCT/DE2000/000821
(87) Internationale Veröffentlichungsnummer: WO 2000/067307

(56) Entgegenhaltungen:
- EP-A- 0 200 951
- EP-A- 0 414 372
- DE-A- 19 706 682
- US-A- 4 726 879
- US-A- 4 855 017
- US-A- 5 047 115
- US-A- 5 458 734
- US-A- 5 498 312
- PATENT ABSTRACTS OF JAPAN vol. 1996, no. 09, 30. September 1996 (1996-09-30) & JP 08 134651 A (MORI YUZO;CENTRAL GLASS CO LTD), 28. Mai 1996 (1996-05-28)
- FLAMM D L ET AL: "Multiple-etchant loading effect and silicon etching in ClF/sub 3/ and related mixtures" JOURNAL OF THE ELECTROCHEMICAL SOCIETY, DEC. 1982, USA, Bd. 129, Nr. 12, Seiten 2755-2760, XP000939284 ISSN: 0013-4651

## Beschreibung

### Stand der Technik

Die Erfindung betrifft Verfahren zum Plasmaätzen, insbesondere zum anisotropen Plasmaätzen, von Silizium nach der Gattung der unabhängigen Ansprüche.

### Stand der Technik

Aus DE 197 06 682 C2 ist ein Verfahren zum anisotropen Hochratenplasmaätzen von Silizium bekannt, wobei zur Seitenwandpassivierung als passivierendes Material SiO₂ verwendet wird, das aus dem Zusatz von SiF₄ und O₂ zur eigentlichen Ätzchemie von SF₆ gebildet wird. Gleichzeitig werden dem Ätzgas als SiO₂-verzehrende Additive ("Scavenger") kontinuierlich oder getaktet CHF₃, CF₄, C₂F₆ oder C₄F₈ zugesetzt, um auf dem Strukturgrund befindliches SiO₂ selektiv abzutragen.

Ein weiteres Hochratenätzverfahren für Silizium wird beispielsweise in DE 42 41 045 C2 vorgeschlagen, wobei eine hochdichte Plasmaquelle mit induktiver Hochfrequenzanregung (ICP-Quelle) oder einer speziellen Mikrowellenanregung (PIE-Quelle) dazu benutzt wird, um aus einem fluorliefernden Ätzgas Fluorradikale und aus einem teflonbildende Monomere liefernden Passiviergas (CF₂)ₓ - Radikale freizusetzen, die ein teflonartiges, passivierendes Material bilden, wobei Ätz- und Passiviergas alternierend eingesetzt werden.

Aus EP-A-0 414 372 ist die Verwendung von 10 bis 90 % CIF₃ in der Ätzung von Silizium bekannt.

Schließlich ist aus der Anmeldung DE 43 17 623 A1 bekannt, ein Gemisch aus SF₆ oder einem anderen fluorliefernden Ätzgas und CHF₃ oder einem anderen, teflonartige Monomere bildenden Passiviergas, einem hochdichten Plasma auszusetzen, so daß die Fluorradikale den Siliziumstrukturgrund ätzen und gleichzeitig die teflonartige Monomere ein passivierendes Material auf den Strukturseitenwänden bilden, und somit für ein anisotropes Verhalten des Ätzprozesses sorgen.

Aufgabe der vorliegenden Erfindung ist es, bestehende Plasmaätzverfahren für Silizium dahingehend zu verbessern, daß durch Einsatz neuer Prozeßgase höhere Ätzraten, geringere Profilabweichungen beim Ätzen und eine bessere Umweltverträglichkeit des Prozeßgases gewährleistet sind.

### Vorteile der Erfindung

Die erfindungsgemäßen Verfahren mit den kennzeichnenden Merkmalen der unabhängigen Ansprüche haben gegenüber dem Stand der Technik den Vorteil, daß damit eine Verbesserung der Profilkontrolle und eine höhere Ätzrate bei Plasmaätzverfahren von Silizium, insbesondere bei anisotropen Hochratenplasmaätzverfahren, erreicht wird. Gleichzeitig sind die eingesetzten Prozeßgase insbesondere hinsichtlich des Treibhauseffektes wesentlich umweltverträglicher als bisher eingesetzte Ätzgase oder Additive und damit auch langfristig verfügbar.

Weiterhin werden bei der Verwendung der fluorliefernden Ätzgase ClF₃, BrF₃ oder IF₅ schon bei relativ geringer Plasmaanregung große Fluormengen freigesetzt, so daß diese sehr effizient hinsichtlich der Anregung und der erreichten hohen Siliziumätzraten sind und gleichzeitig nur geringe Anforderungen an den Leistungsbedarf einer beispielsweise induktiven Plasmaquelle oder einer Mikrowellen-Plasmaquelle stellen. Weiterhin ist sehr vorteilhaft, daß insbesondere ClF₃ beim Zerfall zu ClF oder BrF₃ beim Zerfall zu BrF leichter und in größerer Zahl Fluorradikale freisetzt, als das bekannte SF₆ über dessen vorrangigen Zerfallskanal zu SF₄. Überdies benötigt die Reaktion von ClF₃ zu ClF und 2F^{*} bzw. BrF₃ beim Zerfall zu BrF und 2F^{*} auch eine sehr viel geringere Aktivierungsenergie als die Reaktion von SF₆ zu SF₄ und 2F^{*}. Somit treten infolge geringerer benötigter Hochfrequenz- bzw. Mikrowellenleistungen an der Plasmaquelle zur Erzeugung der benötigten großen Fluorradikalmengen dort sehr vorteilhaft auch weniger Störeffekte auf, die im weiteren die erzeugten Ätzprofile beeinträchtigen könnten.

Weitere Vorteile resultieren aus der Tatsache, daß bei Verwendung von Interhalogenfluoriden als fluorliefernde Ätzgase keine Schwefelausscheidungen im Abgasbereich der Ätzanlage auftreten können, die andernfalls beseitigt bzw. unterdrückt werden müssen.

Schließlich sind insbesondere ClF₃ und BrF₃ chemisch instabil und hydrolisieren an Luft mit der Luftfeuchtigkeit leicht zu HF und HCl bzw. HBr. Daher entsteht mit diesen Verbindungen oder Gasen kein Treibhauseffekt, so daß ihre großtechnische Verfügbarkeit unter Umweltgesichtspunkten auch langfristig gesichert ist, was beispielsweise für SF₆ nicht uneingeschränkt gilt.

Das als das passivierende Material, insbesondere SiO₂ oder ein teflonartiges Material, verzehrende Additiv im Prozeßgas zeitweilig eingesetzte NF₃ hat gegenüber aus dem Stand der Technik bekannten Additiven auf Basis von Fluor-Kohlenstoff-Verbindungen den Vorteil, daß ein wesentlich stärkerer Abtrag von dielektrischen Schichten, die den Strukturgrund maskieren, erreicht wird, so daß dieses im jeweiligen Plasmaätzverfahren in gegenüber bekannten Additiven deutlich geringerer Menge eingesetzt werden muß und damit auch insgesamt geringere negative Auswirkungen auf den Gesamtprozeß, insbesondere hinsichtlich einer damit zwangsläufig verbundenen Verdünnung der übrigen aktiven Reaktanten, hat.

Weiter hat das Additiv NF₃ im Gegensatz zu Fluorkohlenwasserstoffen (CHF₃, CF₄, C₃F₆, C₄F₈, C₂F₆ usw.) dank schwacher Hydrolysewirkung eine relativ kurze Lebensdauer an Luft, so daß ebenfalls kein Treibhauseffekt auftritt. NF₃ wird in der Atmosphäre bereits nach kurzer Zeit durch Luftfeuchtigkeit gebunden. Im Gegensatz zu den als Treibhausgasen wirkenden Fluorkohlenwasserstoffen ist also auch hier die großtechnische Verfügbarkeit langfristig gesichert.

Die Zugabe eines leichten und leicht ionisierbaren Gases, d.h. eines Gases mit geringer Atommasse, wie He, H₂ oder Ne, aus dem leicht positiv geladene Ionen erzeugbar sind, zu dem Ätzgas hat den Vorteil, daß damit Aufladungseffekte, die sich insbesondere an Übergängen zwischen dem elektrisch leitfähigen Silizium und elektrisch isolierenden Dielektrika, die beispielsweise als Maskenmaterial oder vergrabene Opferschichten verwendet werden, störend bemerkbar machen, erheblich vermindert werden. Somit wird eine deutliche Profilverbesserung der erzeugten Ätzprofile, insbesondere beim Übergang von Silizium auf eine vergrabene Oxidschicht, eine Polymerstoppschicht oder am Maskenrand, d.h. am Übergang von der dielektrischen Maskierschicht (Photolack oder Hartstoffmaske aus SiO₂) zu dem zu ätzenden Silizium, erzielt.

Dieser Aufladungseffekt beruht darauf, daß negativ geladene Elektronen, die ungerichtet auf die Waferoberfläche einwirken, vorzugsweise auf den Seitenwänden der zu ätzenden Struktur landen, so daß die Seitenwände relativ zum Ätzgrund negativ aufgeladen werden. Innerhalb des elektrisch leitfähigen Siliziums sind diese Elektronen weitgehend frei beweglich, während auf dem elektrisch isolierenden Ätzgrund befindliche positiv geladene Ionen dort fixiert sind. Insgesamt ziehen somit die beweglichen Elektronen in die Übergangszone zwischen Silizium und Dielektrikum, so daß dort große elektrische Feldstärken entstehen, die im stationären Fall schließlich dazu führen, daß im Mittel genausoviele Ionen zur Seitenwand gelangen, wie zuvor Elektronen, weil sie von entsprechend großen elektrischen Feldern zur Seitenwand abgelenkt werden. Dieser Effekt ist als "Notching Phänomen" in die Literatur eingegangen und führt zur Ausbildung großer, in die Seitenwand eingeätzter Taschen.

Die Zugabe eines leichten, leicht ionisierbaren Gases wie beispielsweise He vermindert diese Taschenbildung sehr vorteilhaft erheblich.

Ein anderes Problem, das auf elektrische Aufladungseffekte zurückzuführen ist, und das durch die Zugabe des leichten, leicht ionisierbaren Gases ebenfalls gelöst wird, tritt am oberen Maskenrand auf. Die Oberfläche einer dielektrischen Maskierschicht auf dem Siliziumwafer wird durch sogenanntes "Self-Biasing" vielfach als Folge einer an einer üblichen Substratelektrode angelegten hochfrequenten Spannung negativ aufgeladen ("DC-Bias"). Diese Aufladung erklärt sich aus der unterschiedlichen Beweglichkeit von Elektronen und Ionen, d.h. um im Zeitmittel genausoviele der unbeweglicheren Ionen wie der hochbeweglichen Elektronen zur Oberfläche zu ziehen, muß sich dort eine negative elektrische Vorspannung aufbauen. Wird nun in den Öffnungen einer Maskierschicht in das Silizium hineingeätzt, führen diese Aufladungen der Oberfläche gegenüber der neu erzeugten Siliziumseitenwand zur Konzentration von Elektronen im Übergang von Silizium zur dielektrischen Maskierschicht. Durch Ionenablenkung werden daher verstärkt Ionen in diesen oberen Teil des geätzten Siliziumtrenchgrabens gelenkt, was dort ebenfalls zur Ausbildung von Profilunregelmäßigkeiten oder Taschen führt. Schließlich hat die Zugabe eines leichten, leicht ionisierbaren Gases zu dem Ätzgas den Vorteil, daß der aus DE 42 41 045 bekannte Seitenwandfilmtransportmechanismus dahingehend verbessert wird, daß mehr Polymerabtrag vom Ätzgrund und weniger Polymerabtrag von den Seitenwänden erfolgt, die Selektivität also verbessert wird.

Vorteilhafte Weiterbildungen der Erfindung ergeben sich aus den in den Unteransprüchen genannten Maßnahmen.

So ist es besonders vorteilhaft, daß die erfindungsgemäßen Verfahren auch untereinander kombiniert werden können, wobei die Vorteile der einzelnen Verfahren jeweils weitgehend erhalten bleiben. Im übrigen kann es vorteilhaft sein, dem Ätzgas, dem das passivierende Material bildenden Gas, insbesondere dem SiF₄, dem Additiv oder einem als Reaktionspartner verwendeten Gas wie beispielsweise Sauerstoff, Stickstoff, Kohlendioxid oder einem Stickoxid zusätzlich zur Verdünnung Argon zuzusetzen.

Insgesamt hängt bei den beschriebenen Mechanismen die Größe der elektrischen Felder, die benötigt werden, um das dynamische Gleichgewicht zwischen Ionen- und Elektroneneinfall herzustellen, unmittelbar davon ab, wie leicht sich ankommende Ionen durch elektrische Felder ablenken lassen. Es ist daher offensichtlich, daß relativ schwere Ionen erst durch relativ große Felder abgelenkt werden, während relativ leichte Ionen schon bei relativ kleinen Feldstärken abgelenkt werden und den Ladungsausgleich vollziehen können. Durch das Einbringen einer Ionensorte von kleiner Atommasse wird insofern sehr vorteilhaft erreicht, daß sich nur noch kleine Feldstärken in den beschriebenen Bereichen aufbauen und bereits bei diesen kleinen Feldstärken genügend viele der leichten Ionen so abgelenkt werden, daß sie den Ladungsausgleich vollziehen können.

Die ebenfalls im Ätzverfahren, beispielsweise als ionisierte Moleküle oder Molekülbruchstücke des Ätzgases oder Additives, auftretenden schweren Ionen werden aufgrund ihrer Masse und damit verbundenen Trägheit von diesen elektrischen Feldern nicht mehr abgelenkt, sondern fliegen ungehindert durch bis zum Ätzgrund, wo sie vorteilhaft beispielsweise eine Ätzreaktion oder einen Ätzgrundpolymerabtrag vorantreiben können. Es findet somit durch die Zugabe des leichten, leicht ionisierbaren Gases insgesamt sehr vorteilhaft eine Trennung zwischen leichten Ionen, welche den Ladungsausgleich durchführen, und schweren Ionen statt, welche vorzugsweise auf den Ätzgrund einwirken.

Neben dem Edelgas Helium als leichtes Gas ist bei einigen Plasmaätzprozessen auch die Verwendung von Wasserstoff (H₂) vorteilhaft, sofern dieser mit der Prozeßchemie verträglich ist. Wasserstoff hat als Molekül in ionisierter Form eine Atommasse von lediglich 2 und dissoziert überdies im Plasma besonders leicht zu positiv geladenen Atomen mit der Atommasse 1.

### Ausführungsbeispiele

Das erste Ausführungsbeispiel geht zunächst vom einem anisotropen Plasmaätzprozeß mit einer hochdichten Plasmaquelle, beispielsweise einer ICP-Plasmaquelle, einer ECR-Plasmaquelle oder einer PIE-Plasmaquelle aus, wie er aus DE 197 06 682 C2 bekannt ist.

Anstelle des dort eingesetzten fluorliefernden Ätzgases SF₆ oder NF₃ wird jedoch dem Prozeßgas als Ätzgas in einem ersten Ausführungsbeispiel gasförmiges Chlortrifluorid ClF₃, Bromtrifluorid BrF₃ oder Iodpentafluorid IF₅ oder eine Mischung dieser Gase zugesetzt. Bevorzugt wird Chlortrifluorid oder Bromtrifluorid eingesetzt, das direkt über einen Massenflußregler zugeführt werden kann, da es einen ausreichend hohen Dampfdruck besitzt. Im Fall der Verwendung von flüssigen Bromtrifluorid wird zu dessen Überführung in die Gasphase dessen Temperatur vorzugsweise auf oberhalb von 20°C gehalten. Es ist dabei weiter möglich, zusätzlich in an sich bekannter Weise ein inertes Trägergas, beispielsweise Argon, beizumischen. Anstelle von Argon kann auch Helium verwendet werden.

Weiter werden die aus DE 197 06 682 C2 bekannten SiO₂-verzehrenden Additive (CHF₃, CF₄, C₂F₆ usw.) durch Stickstofftrifluorid NF₃ ersetzt, das dem Prozeßgas kontinuierlich oder bevorzugt getaktet zugesetzt wird. Dieses Additiv dient insbesondere einer beschleunigten Entfernung des passivierenden Materials vom Ätzgrund.

NF₃ zerfällt unter nicht zu intensiver Plasmaanregung, d.h. typischen ICP-Anregungsbedingungen, vorrangig in radikalische Bruchstücke NFₓ (mit x = 1, 2), welche äußerst aggressiv gegenüber dielektrischen Materialien reagieren und somit beispielsweise gegenüber SiO₂, SiN, SiOₓN_{y} (Siliziumoxynitrid) oder teflonartigen Materialien als sehr effiziente abtragende Reaktionspartner wirken.

Die dabei gleichzeitig freigesetzten Fluormengen aus der Dissoziation von NF₃ fallen gegenüber den Fluormengen aus den fluorliefernden Ätzgasen, beispielsweise ClF₃ oder BrF₃, kaum ins Gewicht und tragen außerdem zur Siliziumätzreaktion bei.

Die Passivierung der Strukturseitenwände im Prozeß wird gegenüber der Lehre der DE 197 06 682 C2 unverändert durch den zumindest zeitweiligen Zusatz von SiF₄ und einem Reaktionspartner, ausgewählt aus der Gruppe O₂, N₂O, NO, NOₓ, CO₂, NO₂ oder N₂ zu dem Prozeßgas erreicht. Bevorzugt ist Sauerstoff.

Hinsichtlich der weiteren Prozeßparameter (insbesondere Gasflüsse, Prozeßdrücke, Ionenenergie und eingestrahlte Plasmaleistungen), sei auf die entsprechenden, bereits aus DE 197 06 682 C2 bekannten Parameter verwiesen, die weitgehend beibehalten werden können.

Eine bevorzugte Zusammensetzung des Prozeßgases ausgehend von dem aus DE 197 06 682 C2 bekannten Verfahren ist beispielsweise, durch folgende Rezepturen gegeben:
60 sccm ClF₃ + 50 sccm O₂ + 50 sccm SiF₄ + 70 sccm He + 5 sccm NF₃ bei konstanter Zugabe, 20 mTorr Druck (2,670 Pa), 1000 Watt Hochfrequenzleistung bei einer Frequenz von 13.56 MHz an der Plasmaquelle, 5 Watt bis 20 Watt Hochfrequenzleistung an der Substratelektrode
oder:
100 sccm BrF₃ + 50 sccm O₂ + 50 sccm SiF₄ + 70 sccm He; zusätzliche Zugabe von 30 sccm NF₃ periodisch alle 30 bis 60 Sekunden, vorzugsweise alle 45 Sekunden über eine Zeitdauer von jeweils 5 Sekunden, Druck 20 mTorr, 1000 Watt Hochfrequenzleistung an der Plasmaquelle, 5 Watt bis 30 Watt Hochfrequenzleistung an der Substratelektrode

In weiteren Ausführungsbeispielen der Erfindung wird zunächst von einem Verfahren ausgegangen, wie es aus DE 42 41 045 C1 bekannt ist. In diesem bekannten Verfahren wird eine anisotrope Ätzung von Silizium mittels eines Plasmas, insbesondere mittels eines Mikrowellenplasmas oder eines über eine induktive Plasmaquelle erzeugten Plasmas, vorgenommen, wobei der anisotrope Ätzvorgang in separaten, jeweils alternierend aufeinanderfolgenden Ätz- und Polymerisations- bzw. Passivierschritten getrennt voneinander durchgeführt wird, welche unabhängig voneinander gesteuert sind. Dabei wird während der Polymerisationsschritte auf eine durch eine Ätzmaske definierte laterale Begrenzung von Strukturen ein Polymer aufgebracht, das während der nachfolgenden Ätzschritte jeweils wieder abgetragen wird.

Diese Ausführungsbeispiele für die Prozeßgaszusammensetzung, ausgehend von dem Verfahren gemäß DE 42 41 045 C2, sind gegeben durch die folgenden Rezepturen, bei denen in den Ätzschritten jeweils das fluorliefernde Ätzgas SF₆ durch ClF₃ oder BrF₃ ersetzt ist. Zusätzlich wird dem Prozeßgas in den Ätzschritten als das passivierende Teflonmaterial insbesondere vom Ätzgrund bevorzugt abtragendes Additiv zumindest zeitweise NF₃ zugesetzt. Die Verfahrensparameter in den Passivierschritten werden dabei gegenüber dem vorausgehenden Ausführungsbeispiel unverändert beibehalten.

### Ätzschritt:

200 sccm ClF₃ + 10 sccm NF₃ + 50 sccm He über 10 Sekunden bei 20 mTorr Druck (2,670 Pa), 1000 Watt Hochfrequenzleistung an der Plasmaquelle, 5 Watt bis 20 Watt Hochfrequenzleistung an der Substratelektrode
oder:
Ätzschritt:
200 sccm ClF₃ + 50 sccm He über 10 Sekunden bei 20 mTorr (2,670 Pa) Druck, zusätzlich 30 sccm NF₃ während der ersten 3 Sekunden der Ätzschritte, 1000 Watt Hochfrequenzleistung an der Plasmaquelle, 5 Watt bis 20 Watt Hochfrequenzleistung an der Substratelektrode

Eine weitere Rezeptur sieht bei gegenüber dem Vorstehenden unveränderten Passivierschritten vor, SF₆ als fluorlieferndes Ätzgas durch BrF₃ zu ersetzen, dem als das passivierende Teflonmaterial insbesondere vom Ätzgrund bevorzugt abtragendes Additiv zumindest zeitweise NF₃ zugesetzt wird.

### Ätzschritt:

150 sccm BrF₃ + 50 sccm Ar oder Helium (als inertes Trägergas) + 10 sccm NF₃ über 10 Sekunden, 25 mTorr Druck (3,330 Pa), 1500 Watt Hochfrequenzleistung an der Plasmquelle, 5 Watt bis 30 Watt Hochfrequenzleistung an der Substratelektrode

Durch die durch die Helium- oder Wasserstoffzugabe erreichte Unterdrückung von Profilabweichungen ist es im übrigen ohne weiteres zusätzlich möglich, nun höhere Siliziumätzraten zu erreichen, indem die Leistungsparameter des eingesetzten Plasmaätzprozesses, insbesondere der Plasmaquelle, beispielsweise von 800 Watt auf bis zu 3000 Watt hochskaliert werden.

Durch den erfindungsgemäßen Prozeßgaszusatz von insbesondere He oder H₂ wird schließlich auch die Selektivität zwischen dem Seitenwandpolymerfilmabtrag und Ätzgrundpolymerabtrag während der Ätzschritte dahingehend verbessert, daß der Ätzgrundpolymerabtrag beschleunigt und der Seitenwandpolymerfilmabtrag reduziert wird. Dies ist eine Folge der bevorzugten Ablenkung leichter Ionen zur Seitenwand, während schwere Ionen ungehindert den Ätzgrund erreichen.

Die Zugabe des leichten und leicht zu ionisierenden Gases wie H₂, Ne oder bevorzugt He wird umso wirksamer, je niedriger die Frequenz der Substratelektrodenspannung an der Substratelektrode ist, da die leichten Ionen aufgrund ihrer geringeren Trägheit zunehmend der elektrischen Feldvariation folgen können. Das Anlegen einer hochfrequenten Substratelektrodenspannung über einen Substratspannungsgenerator (Bias Power) an das zu ätzende Substrat ist an sich bekannt und dient üblicherweise zur Beschleunigung von im Plasma erzeugten Ionen auf das Substrat.

Im erläuterten Beispiel wird die eingesetzte hochfrequente Substratspannung dazu in ihrer Frequenz beispielsweise von üblichen 13,56 MHz auf weniger als 2 MHz verringert. Damit wirkt sich der Massenunterschied des leichten Gasbestandteils im Vergleich zu den übrigen Bestandteilen des Ätzgases besonders stark aus.

## Patentansprüche

1. Verfahren zum Plasmaätzen, insbesondere zum anisotropen Plasmaätzen, von lateral definierten Strukturen in einem Siliziumsubstrat, mit einem Prozeßgas, wobei vor und/oder während des Ätzens zumindest auf den Seitenwänden von lateral definierten Strukturen zumindest zeitweilig mindestens ein passivierendes Material abgeschieden wird, wobei dem Prozeßgas zumindest zeitweise ein fluorlieferndes Ätzgas zugegeben wird, das mindestens eine der Verbindungen ausgewählt aus der Gruppe ClF₃, BrF₃ oder IF₅ enthält,
**dadurch gekennzeichnet,**
**daß** dem Prozeßgas weiterhin zumindest zeitweilig als ein das passivierende Material bildendes Gas mindestens ein Gas ausgewählt aus der Gruppe SiF₄, C₄F₈, C₃F₆, C₉F₁₀, C₃F₈ oder C₂F₆ zugesetzt wird.

2. Verfahren nach Anspruch 1, **dadurch gekennzeichnet,**
**daß** dem Prozeßgas zumindest zeitweilig mindestens ein Gas, ausgewählt aus der Gruppe O₂, N₂O, NO, NOₓ, CO₂, Ar, NO₂ oder N₂ zugesetzt wird.

3. Verfahren nach Anspruch 1, **dadurch gekennzeichnet,**
**daß** dem Prozeßgas zumindest zeitweilig mindestens ein das passivierende Material, insbesondere SiO₂ oder ein teflonartiges Material, verzehrendes Additiv, insbesondere CHF₃, CF₄, C₂F₆, C₃F₆, C₄F₈, C₄F₁₀, C₃F₈, ein Fluoralkan oder NF₃ zugesetzt wird.

4. Verfahren nach Anspruch 1, **dadurch gekennzeichnet,**
**daß** dem Prozeßgas.zumindest zeitweilig ein leichtes und leicht zu ionisierendes Gas, insbesondere H₂, He oder Ne, zugesetzt wird.

5. Verfahren zum Plasmaätzen, insbesondere zum anisotropen Plasmaätzen, von lateral definierten Strukturen in einem Siliziumsubstrat, mit einem Prozeßgas, wobei vor und/oder während des Ätzens auf den Seitenwänden von lateral definierten Strukturen zumindest zeitweilig mindestens ein passivierendes Material abgeschieden wird,
**dadurch gekennzeichnet,**
**daß** dem Prozeßgas zumindest zeitweise ein fluorlieferndes Ätzgas zugegeben wird, das mindestens eine der Verbindungen, ausgewählt aus der Gruppe ClF₃, BrF₃ oder IF₅ enthält, daß dem Prozeßgas weiterhin zumindest zeitweilig als ein das passivierende Material verzehrendes Additiv NF₃ zugesetzt wird, und daß dem Prozeßgas zumindest zeitweilig ein leichtes und leicht ionisierbares Gas, insbesondere H₂, He oder Ne, zugesetzt wird.

6. Verfahren nach Anspruch 5, **dadurch gekennzeichnet, daß** dem Prozeßgas weiterhin zumindest zeitweilig mindestens ein das passivierende Material bildendes Gas, ausgewählt aus der Gruppe SiF₄, C₄F₈, C₃F₆, C₄F₁₀, C₃F₈ oder C₂F₆ zugesetzt wird.

7. Verfahren nach Anspruch 5, **dadurch gekennzeichnet, daß** dem Prozeßgas zumindest zeitweilig mindestens ein Gas, ausgewählt aus der Gruppe O₂, N₂O, NO, NOₓ, CO₂, Ar, NO₂ oder N₂ zugesetzt wird.

## Claims

1. Method for plasma etching, in particular for anisotropic plasma etching, of laterally defined structures in a silicon substrate, using a process gas, wherein before and/or during the etching at least one passivating material is deposited at least on the sidewalls of laterally defined structures at least on occasion, wherein a fluorine-supplying etching gas containing at least one of the compounds selected from the group ClF₃, BrF₃ or IF₅ is added to the process gas at least occasionally,
**characterized**
**in that** at least one gas selected from the group SiF₄, C₄F₈, C₃F₆, C₄F₁₀, C₃F₈ or C₂F₆ is furthermore added to the process gas at least on occasion as a gas forming the passivating material.

2. Method according to Claim 1, **characterized in that** at least one gas selected from the group O₂, N₂O, NO, NOₓ, CO₂, Ar, NO₂ or N₂ is added to the process gas at least on occasion.

3. Method according to Claim 1, **characterized in that** at least one additive that scavenges the passivating material, in particular SiO₂ or a Teflon-like material, said additive being in particular CHF₃, CF₄, C₂F₆, C₃F₆, C₄F₈, C₄F₁₀, C₃F₈, a fluoroalkane or NF₃, is added to the process gas at least on occasion.

4. Method according to Claim 1, **characterized in that** a light gas that can readily be ionized, in particular H₂, He or Ne, is added to the process gas at least on occasion.

5. Method for plasma etching, in particular for anisotropic plasma etching, of laterally defined structures in a silicon substrate, using a process gas, wherein before and/or during the etching at least one passivating material is deposited on the sidewalls of laterally defined structures at least on occasion,
**characterized**
**in that** a fluorine-supplying etching gas containing at least one of the compounds selected from the group ClF₃, BrF₃ or IF₅ is added to the process gas at least occasionally, NF₃ is furthermore added to the process gas at least on occasion as an additive that scavenges the passivating material, and in that a light gas that can readily be ionized, in particular H₂, He or Ne, is added to the process gas at least on occasion.

6. Method according to Claim 5 **characterized in that** at least one gas forming the passivating material, selected from the group SiF₄, C₄F₈, C₃F₆, C₄F₁₀, C₃F₈ or C₂F₆, is furthermore added to the process gas at least on occasion.

7. Method according to Claim 5, **characterized in that** at least one gas selected from the group O₂, N₂O, NO, NOₓ, CO₂, Ar, NO₂ or N₂ is added to the process gas at least on occasion.

## Revendications

1. Procédé de gravure plasma, en particulier pour la gravure plasma anisotrope de structures latéralement définies dans un substrat de silicium, avec un gaz de procédé, selon lequel, avant et/ou pendant la gravure, au moins sur les parois latérales de structures latéralement définies, au moins temporairement, au moins une matière passivante se trouve déposée et,
on ajoute au gaz de procédé, au moins par intermittence, un gaz de gravure libérant du fluor, qui contient au moins un composé choisi dans le groupe constitué de ClF₃, BrF₃ ou IF₅,
**caractérisé en ce qu'**
il est en outre ajouté au gaz de procédé, au moins temporairement, au moins un gaz choisi dans le groupe constitué de SiF₄, C₄ F₈, C₃ F₆, C₄ F₁₀, C₃ F₈ ou C₂ F₆, en tant que gaz formant la matière passivante

2. Procédé selon la revendication 1,
**caractérisé en ce qu'**
il est ajouté au gaz de procédé, au moins temporairement, au moins un gaz choisi dans le groupe constitué de O₂, N₂ O, NO, NOₓ, CO₂, Ar, NO₂ ou N₂.

3. Procédé selon la revendication 1,
**caractérisé en ce qu'**
il est ajouté au gaz de procédé, au moins temporairement, au moins un additif qui consomme la matière passivante, en particulier SiO₂, ou une matière du type téflon, en particulier CHF₃, CF₄, C₂F₆, C₃F₆, C₄ F₈, C₄F₁₀, C₃F₈, un fluoroalcane ou NF₃.

4. Procédé selon la revendication 1,
**caractérisé en ce qu'**
il est ajouté au gaz de procédé, au moins temporairement, un gaz léger et facile à ioniser, en particulier H₂, He ou Ne.

5. Procédé pour la gravure plasma, en particulier pour la gravure plasma anisotrope de structures latéralement définies dans un substrat de silicium, avec un gaz de procédé, selon lequel, avant et/ou pendant la gravure, se trouve déposée, au moins temporairement, au moins une matière passivante, sur les parois latérales de structures latéralement définies,
**caractérisé en ce qu'**
il est ajouté au gaz de procédé, au moins par intermittence, un gaz de gravure libérant du fluor, qui contient au moins un composé choisi dans le groupe constitué de ClF₃, BrF₃ ou IF₅,
il est en outre ajouté au gaz de procédé, au moins temporairement, NF₃, en tant qu'additif consommant la matière passivante, et il est ajouté au gaz de procédé, au moins temporairement, un gaz léger facilement ionisable, en particulier H₂, He ou Ne.

6. Procédé selon la revendication 5,
**caractérisé en ce qu'**
il est en outre ajouté au gaz de procédé, au moins temporairement, au moins un gaz formant la matière passivante choisi dans le groupe constitué de SiF₄, C₄ F₈, C₃ F₆, C₄ F₁₀, C₃ F₈ ou C₂ F₆.

7. Procédé selon la revendication 5,
**caractérisé en ce qu'**
il est ajouté au gaz de procédé, au moins temporairement, au moins un gaz choisi dans le groupe constitué de O₂, N₂ O, NO, NOₓ, CO₂, Ar, NO₂ ou N₂.
